# EUROPEAN PATENT APPLICATION

(11) **EP 4 503 115 A1**
(43) Date of publication of application: **05.02.2025**
(21) Application number: 23816043.6
(22) Date of filing: 30.05.2023
(51) Int. Cl.: H01L 23/13, H01L 23/12, H05K 1/02, H05K 3/18, H05K 3/28

(54) **CERAMIC CIRCUIT SUBSTRATE AND SEMICONDUCTOR DEVICE USING SAME**

(30) Priority: 02.06.2022 JP 2022090095
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: SASAKI, Akito, Yokohama-shi, Kanagawa 235-0032 (JP); IWAI, Kentaro, Yokohama-shi, Kanagawa 235-0032 (JP); KANAHARA, Keita, Yokohama-shi, Kanagawa 235-0032 (JP)
(74) Representative: Henkel & Partner mbB
(86) International application number: PCT/JP2023/020064
(87) International publication number: WO 2023/234286

(57) **Abstract**

Provided is a ceramic circuit substrate having a favorable adhesion with a mold resin. A ceramic circuit substrate according to an embodiment of the present invention comprises a ceramic substrate and a plurality of metal parts. The ceramic substrate has a first surface. The plurality of metal parts are respectively provided in a plurality of first regions of the first surface. The first surface has a second region positioned between the adjacent first regions. The average length RSm of roughness curve elements in the second region is 40 µm or more. The average length RSm is preferably 100 µm or less. The maximum peak height Rp of the roughness curve for the surface in the second region is preferably 1.0 µm or more. The maximum valley depth Rv of the roughness curve for the surface in the second region is preferably 1.0 µm or more.

## Description

### [Technical Field]

Embodiments described below relate generally to a ceramic circuit substrate and a semiconductor device using the ceramic circuit substrate.

### [Background Art]

The output of power modules mounted in industrial devices is increasing in recent years as the performance of industrial devices increases. Accordingly, the output of semiconductor elements is increasing. The guaranteed operating temperature of a semiconductor element is 125 °C to 150 °C, but there is a possibility of increasing to not less than 175 °C in the future. A ceramic circuit substrate is used as a circuit substrate to which a semiconductor element is mounted. The ceramic circuit substrate includes a ceramic substrate, and a metal plate bonded on the ceramic substrate. For example, in Japanese Patent No. 6789955 (Patent Literature 1), a jutting part is included in which a bonding layer juts from a metal plate end portion. In Patent Literature 1, the TCT characteristics (the heat resistance cycle characteristics) are improved by controlling the hardness and/or size of the bonding layer jutting part.

Also, there are cases where resin molding is performed to protect the semiconductor element. The mold resin performs the role of protecting the semiconductor element, wiring parts, etc., from external stress. The mold resin also performs the role of protecting the semiconductor element, etc., from outside air such as moisture, etc.

The adhesion between the ceramic circuit substrate and the mold resin has become a problem as the guaranteed operating temperature of the semiconductor element has increased. The difference between the thermal expansion coefficient of the ceramic circuit substrate and the thermal expansion coefficient of the mold resin is problematic in that the mold resin delaminates from the ceramic circuit substrate. Delamination of the mold resin causes conduction defects of the semiconductor element, etc.

For example, in International Publication No. 2018/173921 (Patent Literature 2), a recess is provided in a copper plate of a ceramic circuit substrate. Also, in JP-A 2021-68850 (Kokai) (Patent Literature 3), a recess is provided in a ceramic substrate.

### [Prior Art Documents]

### [Patent Literature]

Patent Literature 1: Japanese Patent No. 6789955
Patent Literature 2: International Publication No. 2018/173921
Patent Literature 3: JP-A 2021-68850 (Kokai)
Patent Literature 4: International Publication No. 2019/054294

### [Summary of Invention]

### [Problem to be Solved by the Invention]

In the ceramic circuit substrates of Patent Literature 2 and Patent Literature 3, the adhesion with the mold resin is improved by providing a recess in the metal plate or the ceramic substrate. On the other hand, the mounting density of semiconductor elements on ceramic circuit substrates has been increasing in recent years. Examples of methods to increase mounting density include increasing the mounting area of the semiconductor elements on the metal plate surfaces. Examples of methods to increase the mounting area of the metal plate surfaces include increasing the flat surfaces of the metal plates. There is also a method in which the mounting area of the metal plates is increased by reducing the distance between the metal plates. According to a method of providing a recess in a metal plate as in Patent Literature 2, the mounting area cannot be increased. It cannot be said that conventional ceramic circuit substrates have sufficiently realized both adhesion with the mold resin and ensuring the mounting area.

Embodiments are directed to address such problems, and to provide a ceramic circuit substrate that realizes both adhesion with the mold resin and ensuring the mounting area.

### [Means for Solving the Problem]

A ceramic circuit substrate according to an embodiment includes a ceramic substrate and multiple metal parts. The ceramic substrate includes a first surface. The multiple metal parts are located respectively in multiple first regions of the first surface. The first surface includes a second region positioned between adjacent first regions of the multiple metal parts. An average length RSm of roughness curve elements in the second region is not less than 40 µm.

### [Brief Description of Drawings]

[FIG. 1]

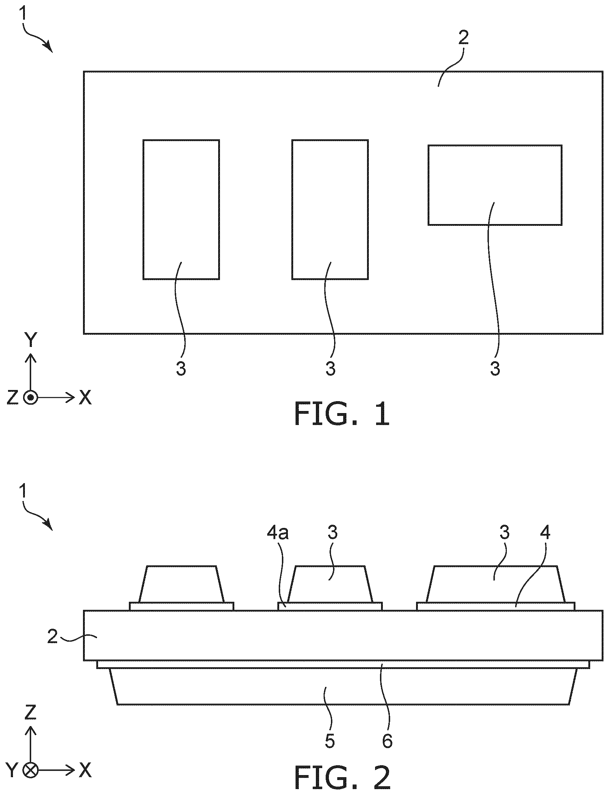

   FIG. 1 is a plan view showing an example of a ceramic circuit substrate according to an embodiment.
[FIG. 2]
   FIG. 2 is a side view showing an example of the ceramic circuit substrate according to the embodiment.
[FIG. 3]

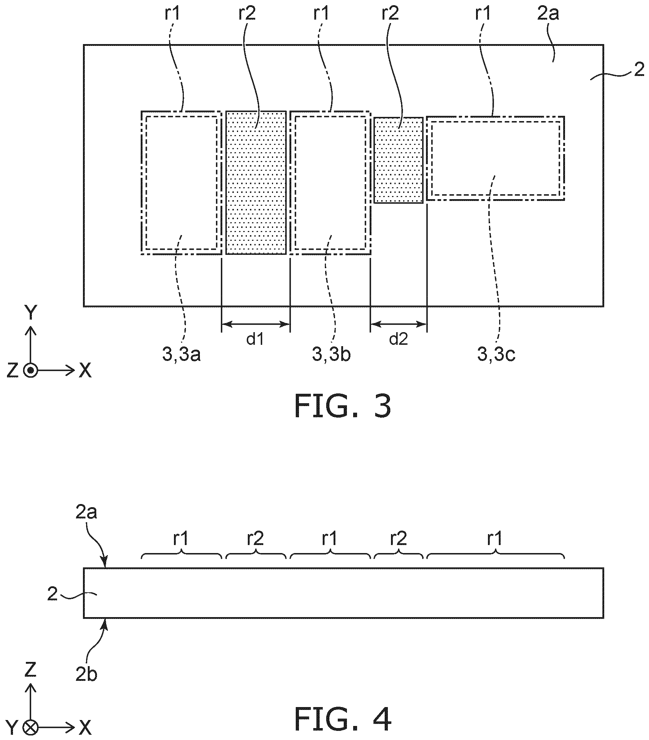

   FIG. 3 is a plan view showing an example of a ceramic substrate.
[FIG. 4]
   FIG. 4 is a side view showing an example of the ceramic substrate.
[FIG. 5]

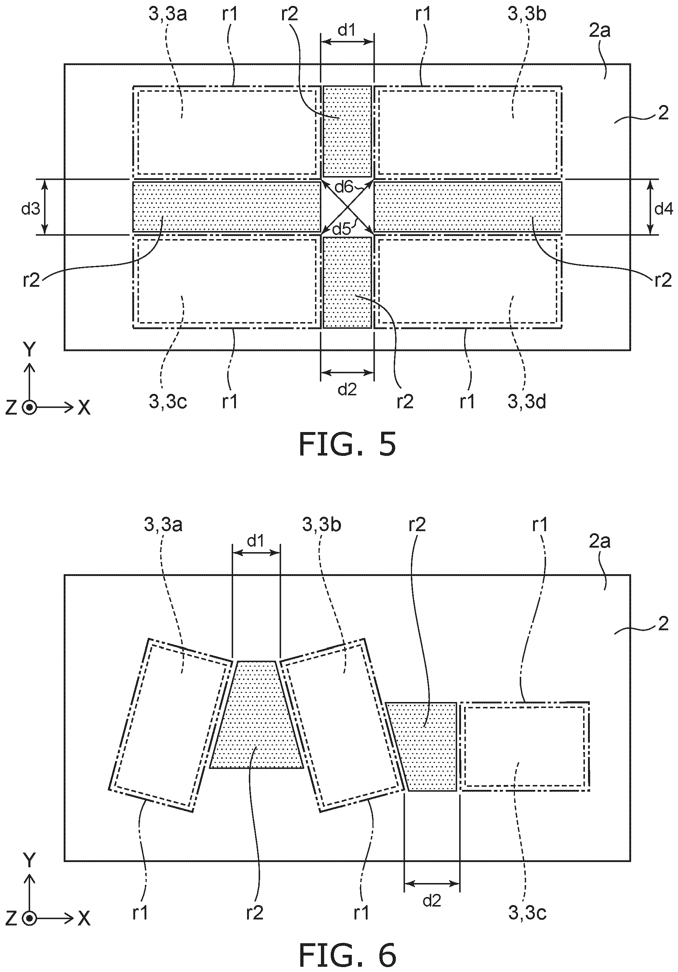

   FIG. 5 is a plan view showing another example of the ceramic substrate.
[FIG. 6]
   FIG. 6 is a plan view showing another example of the ceramic substrate.
[FIG. 7]

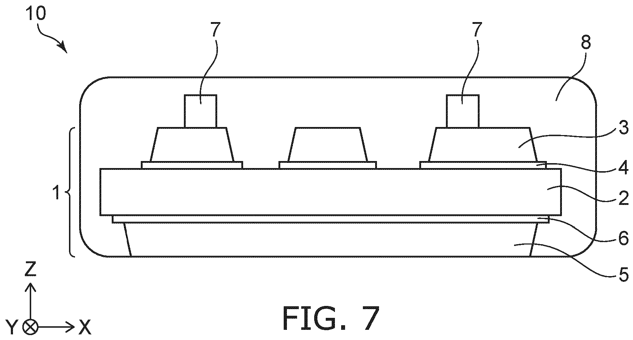

   FIG. 7 is a side view showing an example of a semiconductor device according to an embodiment.

### [Detailed Description]

A ceramic circuit substrate according to an embodiment includes a ceramic substrate and multiple metal parts. The ceramic substrate includes a first surface. The multiple metal parts are located respectively in multiple first regions of the first surface. The first surface includes a second region positioned between adjacent first regions of the multiple metal parts. An average length RSm of roughness curve elements in the second region is not less than 40 µm.

FIG. 1 is a plan view showing an example of a ceramic circuit substrate according to an embodiment. FIG. 2 is a side view showing an example of the ceramic circuit substrate according to the embodiment. In FIGS. 1 and 2, the reference numeral 1 is a ceramic circuit substrate. The reference numeral 2 is a ceramic substrate. The reference numeral 3 is a metal part. In the ceramic circuit substrate 1, the multiple metal parts 3 are located on at least one surface of the ceramic substrate 2 with multiple bonding layers 4 interposed.

FIG. 3 is a plan view showing an example of the ceramic substrate. FIG. 4 is a side view showing an example of the ceramic substrate. In FIGS. 3 and 4, the reference numeral 2a is a first surface (the front surface) of the ceramic substrate 2. The reference numeral 2b is a second surface (the back surface) of the ceramic substrate 2. The second surface 2b is positioned at the side opposite to the first surface 2a.

As shown in FIGS. 3 and 4, the first surface 2a includes two or more first regions r1 and one or more second regions r2. In FIG. 3, the first regions r1 are illustrated by double dot-dash lines. The second regions r2 are illustrated by marking with dots. Also, in FIG. 3, the metal parts 3 that are bonded to the first surface 2a are illustrated by broken lines. The metal parts 3 are bonded to the first regions r1. The second regions r2 are positioned between the first regions r1. The metal parts 3 are not located on the second regions r2. The second region r2 also is called an inter-pattern region. In the illustrated example, three metal parts 3 are located at the ceramic substrate 2. In such a case, the first surface 2a of the ceramic substrate 2 includes three first regions r1 and two second regions r2.

More specifically, the second region r2 is the region positioned between the adjacent first regions r1 in a direction in which the distance between the adjacent metal parts 3 is shortest. Here, a direction parallel to the thickness direction of the ceramic substrate 2 is taken as a "Z-direction". Two mutually-orthogonal directions perpendicular to the Z-direction are taken as an "X-direction" and a "Y-direction". For convenience, the X-direction is taken to be the long-side direction of the ceramic substrate 2, and the Y-direction is taken to be the short-side direction. In the example shown in FIG. 3, the multiple metal parts 3 include a metal part 3a, a metal part 3b, and a metal part 3c. A distance d1 between the metal part 3a and the metal part 3b is shortest in the X-direction. Therefore, the region positioned in the X-direction between the first region r1 to which the metal part 3a is bonded and the first region r1 to which the metal part 3b is bonded is the second region r2. Similarly, a distance d2 between the metal part 3b and the metal part 3c is the shortest in the X-direction. The region in the X-direction between the first region r1 to which the metal part 3b is bonded and the first region r1 to which the metal part 3c is bonded is the second region r2.

FIGS. 5 and 6 are plan views showing other examples of the ceramic substrate. In the example shown in FIGS. 5 and 6, the sizes and positions of the metal parts 3 bonded to the ceramic substrate 2 are different from those of the example shown in FIGS. 1 to 4. In the example shown in FIGS. 1 to 4, the shape of each metal part 3 is rectangular when viewed along the Z-direction; and the longitudinal directions of the metal parts 3 are parallel to each other. In the example shown in FIG. 5, the multiple metal parts 3 are arranged in the X-direction and Y-direction. In the example shown in FIG. 6, the multiple metal parts 3 are arranged so that the longitudinal directions of the metal parts 3 are oblique to each other.

For the arrangements shown in FIGS. 5 and 6 as well, the second region r2 at the first surface 2a is determined by a method similar to that of the example shown in FIG. 3. Specifically, the metal parts 3a to 3d are included in the example shown in FIG. 5. The distance d1 between the metal part 3a and the metal part 3b and the distance d2 between the metal part 3c and the metal part 3d are shortest in the X-direction. The region positioned in the X-direction between the first region r1 to which the metal part 3a is bonded and the first region r1 to which the metal part 3b is bonded is the second region r2; and the region positioned in the X-direction between the first region r1 to which the metal part 3c is bonded and the first region r1 to which the metal part 3d is bonded is the second region r2. Also, a distance d3 between the metal part 3a and the metal part 3c and a distance d4 between the metal part 3b and the metal part 3d are shortest in the Y-direction. The region positioned in the Y-direction between the first region r1 to which the metal part 3a is bonded and the first region r1 to which the metal part 3c is bonded is the second region r2; and the region positioned in the Y-direction between the first region r1 to which the metal part 3b is bonded and the first region r1 to which the metal part 3d is bonded is the second region r2.

Also, a distance d5 between the metal part 3a and the metal part 3d and a distance d6 between the metal part 3b and the metal part 3c are shortest in directions oblique to the X-direction and Y-direction. Accordingly, the region positioned in the oblique direction between the first region r1 to which the metal part 3a is bonded and the first region r1 to which the metal part 3d is bonded may be the second region r2; and the region positioned in the oblique direction between the first region r1 to which the metal part 3b is bonded and the first region r1 to which the metal part 3c is bonded may be the second region r2. However, locations at which the distance between the metal parts 3 is greater than 3 mm are not treated as the second regions r2. For example, even when the shortest distance between the metal parts 3 is not more than 3 mm, a region for which the distance between the metal parts 3 is greater than 3 mm is not included in the second region r2.

In the example shown in FIG. 6, the distance d1 between the metal part 3a and the metal part 3b and the distance d2 between the metal part 3b and the metal part 3c are shortest in the X-direction. Therefore, the region positioned in the X-direction between the first region r1 to which the metal part 3a is bonded and the first region r1 to which the metal part 3b is bonded is the second region r2. The region in the X-direction between the first region r1 to which the metal part 3b is bonded and the first region r1 to which the metal part 3c is bonded is the second region r2. However, the distance between a portion of the first region r1 to which the metal part 3a is bonded and a portion of the first region r1 to which the metal part 3b is bonded is greater than 3 mm. Therefore, the region between the aforementioned portion of the first region r1 to which the metal part 3a is bonded and the aforementioned portion of the first region r1 to which the metal part 3b is bonded is not included in the second region r2.

Also, in FIGS. 1 and 2, the reference numeral 4 is a bonding layer located at the first surface 2a. The reference numeral 5 is a metal part. The metal part 5 also is called the back metal part. The reference numeral 6 is a bonding layer located at the second surface 2b. The metal part 3 may be directly bonded to the first surface 2a, or may be bonded to the first surface 2a via the bonding layer 4 as shown in FIGS. 1 and 2. The metal part 5 may be bonded to the second surface 2b as shown in FIG. 2. The metal part 5 may be directly bonded to the second surface 2b, or may be bonded to the second surface 2b via the bonding layer 6 as shown in FIG. 2. The metal part 5 is used as a heat dissipation plate. The metal part 5 is used to bond to a heat sink, a housing, or the like, which is not illustrated. In the ceramic circuit substrate 1 according to the embodiment, the metal part 5 may be used as a circuit.

When the metal part 3 is bonded to the first surface 2a via the bonding layer 4, it is favorable for the bonding layer 4 to include a jutting part 4a. The jutting part 4a is a part of the bonding layer 4 jutting from the end portion of the metal part 3. When the bonding layer 4 includes the jutting part 4a, the region of the first surface 2a that contacts the jutting part 4a also is included in the first region r1. The second region r2 is positioned between the first regions r1 that contact the bonding layers 4 including the jutting parts 4a. That is, when viewed along the Z-direction, the second region r2 is a region that overlaps neither the metal parts 3 nor the bonding layers 4 (including the jutting parts 4a).

The ceramic circuit substrate 1 according to the embodiment is characteristic in that the average length RSm of the roughness curve elements in the second region r2 of the first surface 2a is not less than 40 µm. The average length RSm of the roughness curve elements is the average value of lengths Xs of the contour curve elements along a reference length. The average length RSm of the roughness curve elements is defined in JIS-B-0601 (2013). To measure the average length RSm of the roughness curve elements as defined in JIS-B-0601 (2013), it is necessary to identify the minimum height and the minimum length used to determine the peaks and valleys. The standard value of the minimum identifiable height is taken to be 10% of the maximum height roughness Rz. The standard value of the minimum identifiable length is taken to be 1% of the reference length. The average value of the lengths Xs of the contour curve elements is determined after determining the peaks and valleys that satisfy both of these two conditions. It is noted that JIS-B-0601 corresponds to ISO 4287.

The average length RSm of the roughness curve elements being not less than 40 µm means that one peak and valley cycle is not less than 40 µm. RSm being not less than 40 µm in the second region r2 means that one peak and valley cycle is large. The adhesion between the ceramic substrate 2 and the mold resin when molding the ceramic circuit substrate 1 with a resin can be improved thereby. RSm of conventional ceramic substrates has been small, and has been less than 40 µm. When the peak and valley cycle is small, a microscopic gap is formed between the ceramic substrate 2 and the mold resin. Generally, the thermal expansion coefficient of the mold resin is greater than the thermal expansion coefficient of the ceramic substrate 2. When the temperatures of the ceramic substrate 2 and the mold resin change due to the heat of a semiconductor element, the thermal conductivity difference generates stress at the interface between the ceramic substrate 2 and the mold resin. When the microscopic gap is present between the ceramic substrate 2 and the mold resin, the mold resin easily delaminates from the ceramic substrate 2 due to stress generated by the heat of the semiconductor element.

Also, the mold resin that is at the second region r2 vicinity is easily affected by the heat of the semiconductor element mounted to the metal part. Generally, the thermal conductivity of the metal part 3 is greater than the thermal conductivity of the ceramic substrate 2. The heat of the semiconductor element is dissipated via the metal part 3. By including the jutting part 4a, the stress that is generated at the metal part 3a end portion is relaxed. On the other hand, the heat that is conducted to the metal part 3 also is conducted to the second region r2 in which the metal part 3 is not located. Because the metal part 3 is not located in the second region r2, the heat that is conducted to the second region r2 is difficult to dissipate. Therefore, the temperature at the second region r2 vicinity easily increases. Also, the stress that is caused by the thermal expansion of the metal part 3 is applied to the mold resin contacting the second region r2. Therefore, compared to the other parts, the mold resin delaminates from the ceramic substrate 2 more easily between the second region r2 and the mold resin.

According to the embodiment, the adhesion between the ceramic substrate 2 and the mold resin can be improved by controlling RSm in the second region r2. When the adhesion between the ceramic substrate 2 and the mold resin is improved, the mold resin catches on the peaks and valleys of the surface of the second region r2 when stress is applied to the mold resin in a direction parallel to the X-Y plane. In other words, an anchor effect for the mold resin is generated. Delamination of the mold resin from the ceramic substrate 2 can be suppressed thereby. The embodiment is particularly effective for a ceramic circuit substrate in which locations are present at which the gap between the metal parts 3 is not more than 3 mm.

Although the upper limit of the average length RSm of the roughness curve elements is not particularly limited, it is favorable for the upper limit to be not more than 100 µm. When RSm is large and is greater than 100 µm, there is a possibility that RSm may be difficult to control. It is therefore favorable for RSm in the second region r2 to be within the range of not less than 40 µm and not more than 100 µm, and more favorably within the range of not less than 50 µm and not more than 80 µm.

Also, it is favorable for the maximum peak height Rp of the roughness curve in the second region r2 to be not less than 1.0 µm. It is favorable for the maximum valley depth Rv of the roughness curve in the second region r2 to be not less than 1.0 µm. The maximum peak height Rp of the roughness curve and the maximum valley depth Rv of the roughness curve also are defined in JIS-B-0601 (2013).

The maximum peak height Rp of the roughness curve is the height of the largest peak of the roughness curve. By setting Rp to be not less than 1.0 µm, the adhesion between the ceramic substrate 2 and the mold resin can be improved. When Rp is less than 1.0 µm, there is a possibility that the adhesion between the ceramic substrate 2 and the mold resin may degrade. Although the upper limit of Rp is not particularly limited, it is favorable for the upper limit to be not more than 3.0 µm. When Rp is large and is greater than 3.0 µm, there is a possibility that locations may occur at which the mold resin does not penetrate gaps of the unevenness of the surface of the second region r2. It is therefore favorable for Rp to be within the range of not less than 1.0 µm and not more than 3.0 µm, and more favorably within the range of not less than 1.2 µm and not more than 2.0 µm.

The maximum valley depth Rv of the roughness curve is the depth of the largest valley in the roughness curve. By setting Rv to be not less than 1.0 µm, the adhesion between the ceramic substrate 2 and the mold resin can be improved. When Rv is less than 1.0 µm, there is a possibility that the adhesion between the ceramic substrate 2 and the mold resin may degrade. Although the upper limit of Rv is not particularly limited, it is favorable for the upper limit to be not more than 3.0 µm. When Rv is large and is greater than 3.0 µm, there is a possibility that locations may occur at which the mold resin does not penetrate gaps of the unevenness of the surface of the second region r2. It is therefore favorable for Rv to be within the range of not less than 1.0 µm and not more than 3.0 µm, and more favorably within the range of not less than 1.2 µm and not more than 2.0 µm. Rv increases as the valleys become deeper.

The adhesion between the ceramic substrate 2 and the mold resin can be further improved by controlling one or two among Rp or Rv in addition to controlling RSm described above. The mold resin delaminates even less easily from the ceramic substrate 2.

RSm, Rp, and Rv are measured using methods in accordance with JIS-B-0601 (2013). The measurement conditions are set to: measurement length: 4.0 mm, measurement speed: 0.6 mm/s, form removal: least-squares line, λs filter: on, λs cutoff ratio: 300, cutoff type: Gaussian, cutoff wavelength (Ac): 0.8 mm. When the measurement length of 4.0 mm cannot be ensured in one measurement, the measurement may be performed by dividing into multiple measurements. Also, the measurement direction of the average length RSm of the roughness curve elements in the second region r2 is arbitrary. The measurement length of 4.0 mm is the reference length.

In the ceramic circuit substrate 1 according to the embodiment, the average length RSm of the roughness curve elements in the second region r2 is controlled. For example, when conforming to the measurement conditions described above, RSm is not less than 40 µm no matter which part of the second region r2 is measured. Also, it is favorable for Rp to be not less than 1.0 µm no matter which part of the second region r2 is measured. It is favorable for Rv to be not less than 1.0 µm no matter which part of the second region r2 is measured. Locations at which RSm is less than 40 µm may be present in the first region r1 to which the metal part 3 is bonded.

Also, it is favorable for the total of the areas of the second regions r2 to be within the range of not less than 5% and not more than 50% of the surface area of the first surface 2a. That is, it is favorable for 5 (%) ≤ [second region r2 total area/first surface 2a area]×100 ≤ 50 (%). For example, for a ceramic substrate that is long side 50 mm×short side 40 mm, the surface area of the first surface 2a is 50×40 = 2,000 mm². When only one second region r2 is present in the first surface 2a, the area of the second region r2 corresponds to "the total area of the second region r2" described above. When multiple second regions r2 are present in the first surface 2a, the total of the areas of the second regions r2 corresponds to "the total area of the second region r2" described above. For example, two second regions r2 are present in the example shown in FIGS. 1 to 4. The total of the areas of the two second regions r2 is "the total area of the second region r2".

By setting the total area of the second regions r2 to be within the range of not less than 5% and not more than 50% of the surface area of the first surface 2a, both adhesion of the mold resin and ensuring the mounting area of the semiconductor element can be realized. When the total area of the second regions r2 is less than 5%, there is a possibility that the effect of improving the adhesion between the ceramic substrate 2 and the mold resin may be insufficient. When the total area of the second regions r2 is large and is greater than 50%, there is a possibility that the area for mounting semiconductor elements, etc., may be insufficient. It is therefore favorable for the total area of the second regions r2 to be within the range of not less than 5% and not more than 50% of the surface area of the first surface 2a, and more favorably within the range of not less than 10% and not more than 40%.

Various substrates are applicable to the ceramic substrate 2. Examples of the ceramic substrate include a silicon nitride substrate, an aluminum nitride substrate, an alumina substrate, a zirconium substrate, and an Alusil substrate. The Alusil substrate is a ceramic sintered body in which alumina and zirconia are mixed. It is favorable for the thickness of the ceramic substrate to be not less than 0.2 mm and not more than 3 mm.

It is favorable for the three-point bending strength of the silicon nitride substrate to be not less than 600 MPa. It is favorable for the thermal conductivity of the silicon nitride substrate to be not less than 80 W/m.K. By increasing the strength of the silicon nitride substrate, the substrate thickness can be reduced. It is therefore favorable for the three-point bending strength of the silicon nitride substrate to be not less than 600 MPa, and more favorably not less than 700 MPa. By using the silicon nitride substrate, the substrate thickness can be thin and can be not more than 2 mm, or even not more than 0.40 mm.

The three-point bending strength of the aluminum nitride substrate is about 300 to 450 MPa. On the other hand, the thermal conductivity of the aluminum nitride substrate is not less than 160 W/m·K. Because the strength of the aluminum nitride substrate is low, it is favorable for the substrate thickness to be not less than 0.60 mm. Although the three-point bending strength of the aluminum oxide substrate is about 300 to 450 MPa, the aluminum oxide substrate is inexpensive. Although the three-point bending strength of the Alusil substrate is high and is about 550 MPa, the thermal conductivity is about 30 to 50 W/m.K.

It is favorable to use a silicon nitride substrate as the ceramic substrate 2. Because the silicon nitride substrate has high strength, the heat shrinkage of the mold resin can be withstood. Also, by using the silicon nitride substrate of which the thermal conductivity is not less than 80 W/m·K, the heat dissipation also can be improved. Also, in the silicon nitride substrate, a major part of the silicon nitride crystal grains has an aspect ratio of not less than 1.5. The entanglement of slender silicon nitride crystal grains can increase the strength of the ceramic substrate 2. Also, it is easy to control RSm by randomly orienting slender silicon nitride crystal grains.

Examples of the metal part 3 include a metal plate, a thin film, a metallized film, etc. The thin film refers to an electrically-conductive film formed by sputtering, plating, etc. The metallized film refers to an electrically-conductive film formed by coating a metal powder paste and by firing.

It is favorable for the metal part 3 to be a member made by patterning a metal plate. It is favorable for the thickness of the metal plate (the metal part 3) to be not less than 0.3 mm. By making the metal plate thick, the heat dissipation can be improved. The current-carrying capacity also can be increased. It is therefore favorable for the thickness of the metal plate to be not less than 0.3 mm, and more favorably not less than 0.6 mm. Although the upper limit of the thickness of the metal plate is not particularly limited, it is favorable for the upper limit to be not more than 5 mm. When the thickness is greater than 5 mm, there is a possibility that the control of the inclined shape of the metal part 3 side surface may be difficult. Also, in view of heat dissipation, it is favorable for the metal part 3 to include a copper plate having a thickness of not less than 0.3 mm. Also, it is favorable for the thickness of the metal part 3 and the thickness of the metal part 5 both to be not less than 0.3 mm. By the metal part 3 including the metal plate, the current-carrying capacity and heat dissipation of the metal part 3 can be improved in addition to improving the adhesion between the metal part 3 and the mold resin.

Examples of the metal plate include at least one selected from a copper plate, a copper alloy plate, an aluminum plate, and an aluminum alloy plate. A copper plate is favorable as the metal plate. An oxygen-free copper plate also is favorable. Oxygen-free copper has a copper purity of not less than 99.96 wt% as defined in JIS-H-3100. The thermal conductivity of copper is about 400 W/m.K; and the thermal conductivity of aluminum is about 240 W/m·K. Copper has a higher thermal conductivity than aluminum. By the metal part 3 including a copper plate, the heat dissipation of the metal part 3 is improved. Also, it is favorable for the aluminum plate to be pure aluminum. Pure aluminum is defined in JIS-H-4000. It is noted that JIS-H-4000 corresponds to ISO 6361. JIS-H-3100 corresponds to ISO 197, etc.

It is favorable to bond the ceramic substrate 2 and the metal part 3 via the bonding layer 4. It is favorable for the bonding layer 4 to be a member formed using active metal bonding. Active metal bonding is a bonding method that uses one, two, or more active metals selected from Ti (titanium), Zr (zirconium), and Hf (hafnium). An active metal brazing material that includes an active metal and has copper (Cu) or silver (Ag) as a major component is used. Here, the major component refers to the most abundant component among the metal components of the brazing material.

It is favorable for the active metal brazing material to include not less than 0 mass% and not more than 60 mass% of Ag (silver), not less than 15 mass% and not more than 70 mass% of Cu (copper), and not less than 1 mass% and not more than 15 mass% of Ti (titanium) or TiH₂ (titanium hydride). When both Ti and TiH₂ are used, the total of Ti and TiH₂ is set to be within the range of not less than 1 mass% and not more than 15 mass%. When both Ag and Cu are used, it is favorable for Ag to be within the range of not less than 20 mass% and not more than 60 mass%, and for Cu to be within the range of not less than 15 mass% and not more than 40 mass%. If necessary, the active metal brazing material may include one or two of Sn (tin) or In (indium) within the range of not less than 1 mass% and not more than 50 mass%. Also, if necessary, the active metal brazing material may include C (carbon) within the range of not less than 0.1 mass% and not more than 2 wt%.

The ratios of the active metal brazing material composition are calculated using the total of mixed raw materials as 100 mass%. For example, when the active metal brazing material includes the three of Ag, Cu, and Ti, then Ag + Cu + Ti = 100 mass%. When the active metal brazing material includes the four of Ag, Cu, TiH₂, and In, then Ag + Cu + TiH₂ + In = 100 mass%. When the active metal brazing material includes the five of Ag, Cu, Ti, Sn, and C, then Ag + Cu + Ti + Sn + C = 100 mass%.

Ag or Cu is a component used as the base material of the brazing material. Sn or In has the effect of lowering the melting point of the brazing material. C (carbon) has the effect of controlling the fluidity of the brazing material and/or controlling the composition of the bonding layer by reacting with other components. Therefore, examples of the components of the brazing material include Ag-Cu-Ti, Ag-Cu-Sn-Ti, Ag-Cu-Ti-C, Ag-Cu-Sn-Ti-C, Ag-Ti, Cu-Ti, Ag-Sn-Ti, Cu-Sn-Ti, Ag-Ti-C, Cu-Ti-C, Ag-Sn-Ti-C, and Cu-Sn-Ti-C. In may be used instead of Sn. Both Sn and In may be used.

At least one selected from tungsten (W), molybdenum (Mo), and rhenium (Re) may be added to the active metal brazing material within the range of not less than 0.1 mass% and not more than 10 mass%. By adding tungsten, molybdenum, or rhenium, the fluidity of the active metal brazing material can be controlled. Magnesium (Mg) may be added to the active metal brazing material.

The active metal brazing material described above is effective for bonding the copper plate. It is favorable for the metal part 3 to be a copper member, and for the ceramic substrate and the copper member to be bonded via a bonding layer not including Ag. The bonding layer that does not include Ag refers to a member formed using an active metal brazing material to which Ag is not added. 0.01 mass% or less of Ag (including zero that is below the detection limit) may be included as an unavoidable impurity. By using the bonding layer not including Ag, the occurrence of Ag ion migration can be suppressed. Ag ion migration is a phenomenon in which the Ag of the bonding layer is ionized and moves when a voltage is applied in an environment of high humidity. When Ag ions move, the Ag precipitates at another location. An insulation defect is caused thereby. Among active metal brazing materials, ion migration occurs most easily for Ag. Ag ion migration can be suppressed by the bonding layer not including Ag.

When the metal plate is an aluminum plate, it is favorable for the active metal brazing material to be an Al-Si-based or AlMg-based brazing material. It is favorable for the content of one or two of Si or Mg among the active metal brazing materials to be within the range of not less than 0.1 mass% and not more than 20 mass%.

The ceramic circuit substrate according to the embodiment can be used in a semiconductor device in which a semiconductor element is mounted to the metal part 3. It is favorable for the ceramic circuit substrate to include a mold resin.

FIG. 7 is a side view showing an example of a semiconductor device according to an embodiment. In FIG. 7, the reference numeral 1 is a ceramic circuit substrate. The reference numeral 6 is a semiconductor element. The reference numeral 7 is a mold resin. The reference numeral 10 is a semiconductor device. The semiconductor element 7 is mounted to the metal part 3. FIG. 7 illustrates the semiconductor device 10 to which two semiconductor elements 7 are mounted. The semiconductor device 10 according to the embodiment is not limited to such a configuration. The number of the semiconductor elements 7 is arbitrary. The semiconductor device 10 may include wire bonding, a leadframe, etc., which are not illustrated.

In the configuration shown in FIG. 7, the first surface 2a to which the semiconductor element 7 is mounted is covered with a mold resin 8. The mold resin 8 is not limited to such a configuration; the mold resin 8 may cover up to the metal part 5 of the semiconductor device 10.

The mold resin 8 performs the role of protecting the semiconductor element 7, wiring parts, etc., from external stress. The mold resin also performs the role of protecting the semiconductor element 7, etc., from outside air such as moisture, etc. The mold resin includes mainly a thermosetting resin. Examples of the thermosetting resin include an epoxy resin, a silicone resin, etc.

Examples of the mold method include transfer, compression, etc. Transfer is a sealing method in which molten resin is injected into a mold and cured. A mold that is formed by transfer is called a transfer mold. Compression is a sealing method in which a resin is fed into the mold beforehand, then melted and cured. A mold that is formed by compression is called a compression mold. Transfer molding has excellent suitability for mass production because transfer molding is a technique for injecting resin. Because resin flow accompanies transfer molding, there is a possibility that misalignment of the semiconductor element, wire bonding, etc., may occur. Because the resin is fed into the mold beforehand and then the resin is melted in compression molding, the effects on misalignment of the semiconductor element, etc., are few. On the other hand, the resin must be fed into the mold beforehand. Therefore, the suitability for mass production for compression molding is less than that of transfer molding.

In the ceramic circuit substrate according to the embodiment, the average length RSm of the roughness curve elements of the ceramic substrate surface at the gap part between the metal parts is set to be not less than 40 µm. One peak and valley cycle is set to be large. The adhesion with the mold resin is improved thereby. The adhesion can be improved for both transfer molding and compression molding methods. For example, resin flow accompanies transfer molding. Even when the resin flows, by setting one peak and valley cycle to be large, the flowing resin penetrates the surface unevenness. The adhesion can be improved thereby. In other words, it is favorable for the semiconductor device 10 to include the mold resin 8.

When measuring the average length RSm of the roughness curve elements at the gap part (the region between the metal parts) of the semiconductor device including the mold resin, the average length RSm is measured after removing the mold resin. Examples of the method for removing the mold resin include chemical treatment that dissolves only the resin, etc.

A method for manufacturing the ceramic circuit substrate 1 according to the embodiment will now be described. The method for manufacturing the ceramic circuit substrate 1 according to the embodiment is not limited as long as the ceramic circuit substrate 1 includes the configuration described above. Here, a method for manufacturing the ceramic circuit substrate 1 with a high yield will be described.

First, a bonded body of the ceramic substrate 2 and a metal plate is prepared. The metal plate is located at one surface or two surfaces of the ceramic substrate 2. It is favorable for the ceramic substrate 2 to be one selected from a silicon nitride substrate, an aluminum nitride substrate, an alumina substrate, a zirconium substrate, and an Alusil substrate. It is favorable for the metal plate to be at least one selected from a copper plate, a copper alloy plate, an aluminum plate, and an aluminum alloy plate. It is favorable to use a method that uses active metal bonding to bond the ceramic substrate 2 and the metal plate.

When the metal plate is a copper plate (including a copper alloy plate), the active metal brazing material includes Cu or Ag as a major component, and further includes at least one selected from Ti, Zr, and Hf. If necessary, at least one selected from Sn, In, or C (carbon) may be added. When the metal plate is an aluminum plate, it is favorable for the active metal brazing material to include an Al-Si-based or Al-Mg-based brazing material. Favorable composition ranges of the active metal brazing material are as described above.

Examples of the bonding process include a process of heating a stacked body of the ceramic substrate and the metal plate at 600 to 980 °C in a vacuum or in inert atmosphere. It is favorable for the pressure in the vacuum to be not more than 10⁻² Pa. A nitrogen atmosphere is favorable as the inert atmosphere. When the bonding process is in a vacuum, it is favorable to use a batch furnace. When the bonding process is in the inert atmosphere, it is favorable to use a continuous furnace. The bonding process prepares a bonded body in which the ceramic substrate 2 and the metal plate are bonded via the bonding layer 4.

Then, an etching process is performed. The etching process is performed to provide the metal plate with a circuit configuration. By providing the metal plate with the circuit configuration, the metal part 3 described above is obtained. Also, by providing the metal plate with the circuit configuration, the ceramic circuit substrate 1 is made. A metal plate that is patterned into a circuit configuration beforehand may be bonded to the ceramic substrate 2. In such a case, it is unnecessary to perform the etching process; and the metal plate that has the circuit configuration corresponds to the metal part 3 described above.

It is effective to utilize the etching process to control RSm, Rp, and Rv. In a bonding layer that uses an active metal brazing material, a layer that includes Ag or Cu as a major component and a layer that includes an active metal as a major component are formed. International Publication No. WO2019/054294 (Patent Literature 4) illustrates a method in which a brazing material etching process and a chemical polishing process are used as the etching process of the bonding layer using the active metal brazing material.

When a portion of the copper plate is etched, a portion of the bonding layer is exposed. In the brazing material etching process, the exposed part of the bonding layer is removed. Also, when a portion of the brazing material is exposed, there is a possibility that the surface of the exposed brazing material may be oxidized. There is also a possibility that the etching process of the copper plate may generate reaction products at the surface of the brazing material. A chemical polishing process is performed to remove oxides or reaction products formed at the surface of the brazing material. By performing the chemical polishing process, the bonding layer can be efficiently removed in the brazing material etching process performed subsequently.

To control RSm, etc., it is effective to increase the etching amount of the brazing material etchant. Effective methods of increasing the etching amount of the brazing material etchant include at least one selected from increasing the etching rate of the brazing material etchant, suppressing a reduction of the etching rate of the brazing material etchant, and increasing the etching time.

Examples of the brazing material etchant include a solution including hydrogen peroxide with a pH of not more than 6. To increase the etching rate of the brazing material etchant, it is effective to increase the concentration of aqueous hydrogen peroxide. Other than hydrogen peroxide, the etchant may include ammonium fluoride and a pH-stabilizing agent. Examples of the pH-stabilizing agent include at least one selected from HBF₄, EDTA, NTA, CyDTA, DTPA, TTHA, GEDTA, glycine, dicarboxylic acid, tricarboxylic acid, oxycarboxylic acid, and salts thereof.

Effective methods for suppressing the reduction of the etching rate of the brazing material etchant include feeding new etchant when the concentration of aqueous hydrogen peroxide changes by 5 mass%. The reduction of the etching rate of the brazing material etchant can be suppressed thereby. Increasing the etching time of the brazing material etching also is effective for controlling RSm. As a guide, the time of one brazing material etching process is set to be not less than 15 minutes.

Also, to control RSm, etc., it is effective to increase the amount of the bonding layer removed by the chemical polishing process. Examples of methods of increasing the amount removed by the chemical polishing process include increasing the concentration of hydrochloric acid or sulfuric acid, and increasing the time that the chemical polishing process is performed. For example, when the brazing material etchant includes a combination of hydrogen peroxide and sulfuric acid, the sulfuric acid is set to be not less than 5 mass%. Examples of methods used when the brazing material etchant includes hydrochloric acid include setting hydrochloric acid to be not less than 7 mass%. It is also effective to set the time that the chemical polishing process is performed to be not less than 5 minutes.

A combination of the brazing material etching process and the chemical polishing process described above may be performed. That is, the methods described above are applicable to each of the chemical polishing process and the brazing material etching process. Also, the chemical polishing process and the brazing material etching process may be alternately performed. In such a case, it is effective to apply the methods described above to the final chemical polishing process among multiple chemical polishing processes, and to apply the methods described above to the final brazing material etching process among multiple brazing material etching processes.

The final brazing material etching process is a process of completely removing the bonding layer. When the ceramic substrate 2 and the metal plate are bonded by active metal bonding, a layer that includes an active metal as a major component is formed. When Ti is used as the active metal and a silicon nitride substrate is used as the ceramic substrate, the layer that includes the active metal as a major component is a layer of titanium nitride (TiN). The bonding strength is increased by forming the layer including the active metal as a major component in the bonding layer. On the other hand, because the layer that includes the active metal as a major component is electrically-conductive, if the ceramic circuit substrate 1 remains, there is a possibility that a conduction defect between the metal parts 3 may be caused. It is therefore necessary to remove the layer including the active metal as a major component. By increasing the removed amount in the etching process or the chemical polishing process, the layer that includes the active metal as a major component and a portion of the ceramic substrate surface under the layer including the active metal as a major component can be removed. RSm and the like can be controlled thereby.

When a metal plate that has a circuit configuration beforehand is bonded to the ceramic substrate 2 and an etching process is not performed, it is effective to perform a chemical polishing process on the gap part between the metal plates. Also, if necessary, a method of controlling RSm, etc., by performing blasting and/or polishing processes of the second region is effective.

By the processes described above, the ceramic circuit substrate 1 according to the embodiment can be manufactured. Also, by mounting the semiconductor element 7, etc., to the ceramic circuit substrate 1, the semiconductor device 10 can be manufactured. If necessary, the semiconductor device 10 includes the mold resin 8.

### (Examples 1 to 7 and comparative examples 1 to 2)

Silicon nitride substrates were prepared as ceramic substrates in examples 1 to 6. The silicon nitride substrates had a thermal conductivity of 90 W/m·K and a three-point bending strength of 700 MPa. The silicon nitride substrates had a longitudinal dimension of 50 mm, a lateral dimension of 40 mm, and a thickness of 0.32 mm. Copper plates having a thickness of 0.8 mm were prepared as the metal plates.

Then, bonded bodies (silicon nitride circuit substrates) of silicon nitride substrates and copper plates were manufactured using active metal bonding. Copper plates having thicknesses of 0.8 mm were bonded respectively to the two surfaces of the silicon nitride substrates. The compositions of the active metal brazing materials were as shown in Table 1.

An aluminum nitride substrate was prepared as the ceramic substrate in the example 7. The aluminum nitride substrate had a thermal conductivity of 170 W/m·K and a three-point bending strength of 400 MPa. Copper plates having thicknesses of 0.4 mm were prepared as the metal plates. The bonded body (the aluminum nitride circuit substrate) was manufactured by bonding the copper plates having thicknesses of 0.4 mm respectively to the two surfaces of the aluminum nitride substrate using active metal bonding. Also, a silicon nitride circuit substrate was manufactured as the comparative example 1. An aluminum nitride circuit substrate was manufactured as the comparative example 2.

**[Table 1]**

| | Active metal brazing material (mass%) |
|---|---|
| Example 1 | Ag(50) , Cu(35) , Sn(10) , TiH₂(5) |
| Example 2 | Ag(43.9) , Cu(33) , Sn(15) , TiH₂(8) , C(0.1) |
| Example 3 | Ag(60) , Cu(32) , Sn(5) , TiH₂(3) |
| Example 4 | Cu(68) , Sn(20) , TiH₂(12) |
| Example 5 | Cu(76.9) , Sn(15) , TiH₂(8) , C(0.1) |
| Example 6 | Cu(70) , Sn(20) , TiH₂(10) |
| Example 7 | Cu(74.8) , Sn(18) , TiH₂(7) , C(0.2) |
| Comparative example 1 | Ag(50) , Cu(35) , Sn(10) , TiH₂(5) |
| Comparative example 2 | Ag(59) , Cu(30) , Sn(8) , TiH₂(3) |

Then, the metal parts 3 were formed by providing circuit configurations to the copper plates by an etching process. For the ceramic circuit substrates according to the examples, the method of increasing the etching amount of the brazing material etchant or the method of increasing the amount removed by the chemical polishing process was used.

The total areas (%) of the second regions r2 were as shown in Table 2 for the manufactured ceramic circuit substrates. The total area (%) of the second regions r2 was calculated by (total of areas of second regions r2/surface area of first surface 2a)×100 (%). The surface area of the first surface 2a was 50 mm long×40 mm wide = 2,000 mm². Also, RSm, Rp, and Rv in the second regions r2 were measured. The methods for measuring RSm, Rp, and Rv were as described above.

**[Table 2]**

| | Total area (%) of second regions r2 | Second region r2 | | |
|---|---|---|---|---|
| | | RSm (µm) | Rp (µm) | Rv (µm) |
| Example 1 | 5 | 45 | 1.2 | 1.5 |
| Example 2 | 10 | 52 | 1.5 | 1.7 |
| Example 3 | 40 | 65 | 1.1 | 2.2 |
| Example 4 | 20 | 74 | 1.4 | 1.9 |
| Example 5 | 30 | 83 | 1.7 | 2.3 |
| Example 6 | 25 | 153 | 2.2 | 2.5 |
| Example 7 | 45 | 112 | 2.0 | 1.7 |
| Comparative example 1 | 10 | 25 | 0.4 | 0.3 |
| Comparative example 2 | 20 | 21 | 0.3 | 0.4 |

For the ceramic circuit substrates according to the examples, RSm was set to be not less than 40 µm. Also, Rp was set to be not less than 1.0 µm, and Rv was set to be not less than 1.0 µm. For the comparative example 1 and the comparative example 2, RSm was set to be less than 40 µm.

Then, semiconductor devices were manufactured by mounting semiconductor elements to the ceramic circuit substrates according to the examples and the comparative examples. Mold resin was provided for the semiconductor devices. Ag migration characteristics and the resin adhesion were measured for the semiconductor devices including the mold resin.

To evaluate the Ag migration characteristics, a voltage was applied to the semiconductor device in a high-temperature high-humidity atmosphere; and the Ag migration filament occurrence ratio was measured. An electrochemical migration evaluation system by ESPEC Corp. was used as the measurement device. An applied voltage of AC 2,000 V (a peak voltage of 2,820 V) was continuously applied to the semiconductor device for 40 hours in an environment of a temperature of 85 °C and a humidity of 85%. The presence or absence of Ag migration filaments at the surface of the ceramic circuit substrate was checked.

One hundred semiconductor devices were evaluated for each example and each comparative example. The number of semiconductor devices in which at least one Ag migration filament was present were counted for each example. Examples in which the count was 0 were taken to be "best". The examples in which the count was not less than 1 and not more than 10 were taken to be "good". The examples in which the count was not less than 11 were taken to be "defective".

For the resin adhesion, the presence or absence of mold resin delamination after the TCT test (the thermal cycle test) was measured. In the TCT test, -40 °C×30 minutes → room temperature (25 °C)×10 minutes → 175 °C×30 minutes → room temperature (25 °C)×10 minutes was used as 1 cycle; and the presence or absence of mold resin delamination after 300 cycles was measured. The presence or absence of resin delamination at the surface of the second region r2 was measured using ultrasonic flaw detection (SAT). The mold resin delamination rate (%) was calculated by (total of resin delamination in second region r2/total area of second regions r2)×100. The results are shown in Table 3.

**[Table 3]**

| | Ag migration | Mold resin delamination rate (%) |
|---|---|---|
| Example 1 | Good | 0 |
| Example 2 | Good | 0 |
| Example 3 | Good | 0 |
| Example 4 | Best | 0 |
| Example 5 | Best | 0 |
| Example 6 | Best | 2 |
| Example 7 | Best | 2 |
| Comparative example 1 | Defective | 4 |
| Comparative example 2 | Defective | 7 |

It can be seen from Table 3 that the adhesion between the ceramic substrate and the resin was favorable for the semiconductor devices according to the examples. The adhesion was improved, even when a recess was not provided in the copper plate as in Patent Literature 2. Therefore, according to the embodiment, a reduction of the mounting area of the semiconductor element can be suppressed.

As in the example 6 and the example 7, resin delamination occurred when RSm was outside the range of not less than 40 µm and not more than 100 µm. Therefore, it can be seen that it is favorable for RSm to be within the range of not less than 40 µm and not more than 100 µm. Also, Ag ion migration did not occur for the examples 4 to 7 that used Ag-less brazing materials. On this point, it is favorable to use Ag-less brazing material. In other words, by using Ag-less brazing material, both Ag ion migration suppression and mold resin adhesion improvement can be realized. In contrast, the adhesion of the mold resin degraded for the comparative examples 1 and 2 because RSm was small.

Embodiments of the invention may include the following configurations.

### Configuration 1

A ceramic circuit substrate, comprising:
a ceramic substrate including a first surface; and
a plurality of metal parts located respectively in a plurality of first regions of the first surface,
the first surface including a second region positioned between adjacent first regions of the plurality of first regions,
an average length RSm of roughness curve elements in the second region being not less than 40 µm.

### Configuration 2

The ceramic circuit substrate according to Configuration 1, wherein
the average length RSm in the second region is not more than 100 µm.

### Configuration 3

The ceramic circuit substrate according to any one of Configurations 1 to 2, wherein
a maximum peak height Rp of a surface roughness curve in the second region is not less than 1.0 µm.

### Configuration 4

The ceramic circuit substrate according to any one of Configurations 1 to 3, wherein
a maximum valley depth Rv of a surface roughness curve in the second region is not less than 1.0 µm.

### Configuration 5

The ceramic circuit substrate according to any one of Configurations 1 to 4, wherein
one or more of the second regions is included, and a sum of areas of the second regions is within a range of not less than 5% and not more than 50% of a surface area of the first surface.

### Configuration 6

The ceramic circuit substrate according to any one of Configurations 1 to 5, wherein
the ceramic substrate is a silicon nitride substrate.

### Configuration 7

The ceramic circuit substrate according to any one of

Configurations 1 to 6, wherein
the plurality of metal parts each are copper members,
the plurality of copper members is bonded respectively to the plurality of first regions via a plurality of bonding layers, and
the plurality of bonding layers does not include Ag.

### Configuration 8

The ceramic circuit substrate according to Configuration 7, wherein
in the second region, a maximum peak height Rp of a roughness curve is not less than 1.0 µm, and a maximum valley depth Rv of the roughness curve is not less than 1.0 µm.

### Configuration 9

The ceramic circuit substrate according to Configuration 8, wherein
one or more of the second regions is included, and a sum of areas of the second regions is within a range of not less than 5% and not more than 50% of a surface area of the first surface.

### Configuration 10

A semiconductor device, comprising:
the ceramic circuit substrate according to any one of Configurations 1 to 9; and
a semiconductor element mounted on one of the plurality of metal parts.

### Configuration 11

The semiconductor device according to Configuration 10, further comprising:
a mold resin covering the second region.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 ceramic circuit substrate
2 ceramic substrate
2a first surface (front surface)
2b second surface (back surface)
3, 3a to 3d metal part
4 bonding layer
5 metal part (back metal part)
6 bonding layer
7 semiconductor element
8 mold resin
10 semiconductor device
r1 first region
r2 second region

## Claims

1. A ceramic circuit substrate (1), comprising:
a ceramic substrate (2) including a first surface (2a); and
a plurality of metal parts (3, 3a to 3d) located respectively in a plurality of first regions (r1) of the first surface (2a),
the first surface (2a) including a second region (r2) positioned between adjacent first regions (r1) of the plurality of first regions (r1),
an average length RSm of roughness curve elements in the second region (r2) being not less than 40 µm.

2. The ceramic circuit substrate (1) according to claim 1, wherein
the average length RSm in the second region (r2) is not more than 100 µm.

3. The ceramic circuit substrate (1) according to any one of claims 1 to 2, wherein
a maximum peak height Rp of a surface roughness curve in the second region (r2) is not less than 1.0 µm.

4. The ceramic circuit substrate (1) according to any one of claims 1 to 2, wherein
a maximum valley depth Rv of a surface roughness curve in the second region (r2) is not less than 1.0 µm.

5. The ceramic circuit substrate (1) according to any one of claims 1 to 2, wherein
one or more of the second regions (r2) is included, and a sum of areas of the second regions (r2) is within a range of not less than 5% and not more than 50% of a surface area of the first surface (2a).

6. The ceramic circuit substrate (1) according to any one of claims 1 to 2, wherein
the ceramic substrate (2) is a silicon nitride substrate.

7. The ceramic circuit substrate (1) according to any one of claims 1 to 2, wherein
the plurality of metal parts (3, 3a to 3d) each are copper members,
the plurality of copper members is bonded respectively to the plurality of first regions (r1) via a plurality of bonding layers (4), and
the plurality of bonding layers (4) does not include Ag.

8. The ceramic circuit substrate (1) according to claim 6, wherein
in the second region (r2), a maximum peak height Rp of a roughness curve is not less than 1.0 µm, and a maximum valley depth Rv of the roughness curve is not less than 1.0 µm.

9. The ceramic circuit substrate (1) according to claim 6, wherein
one or more of the second regions (r2) is included, and a sum of areas of the second regions (r2) is within a range of not less than 5% and not more than 50% of a surface area of the first surface (2a).

10. A semiconductor device (10), comprising:
the ceramic circuit substrate (1) according to any one of claims 1 to 2; and
a semiconductor element (7) mounted on one of the plurality of metal parts (3, 3a to 3d).

11. The semiconductor device (10) according to claim 10, further comprising:
a mold resin (8) covering the second region (r2).

12. A semiconductor device (10), comprising:
the ceramic circuit substrate (1) according to claim 9; and
a semiconductor element (7) mounted on one of the plurality of metal parts (3, 3a to 3d).

13. The semiconductor device (10) according to claim 12, further comprising:
a mold resin (8) covering the second region (r2).
